# EUROPEAN PATENT APPLICATION

(11) **EP 1 806 859 A1**
(43) Date of publication of application: **11.07.2007**
(21) Application number: 05800526.5
(22) Date of filing: 02.11.2005
(51) Int. Cl.: H04J 11/00, H04L 1/00, H04L 27/00

(54) **RADIO COMMUNICATION METHOD, RADIO COMMUNICATION SYSTEM AND RADIO COMMUNICATION EQUIPMENT**

(30) Priority: 05.11.2004 JP 2004321883
(71) Applicant: MATSUSHITA ELECTRIC INDUSTRIAL CO., LTD., Osaka 571-8501 (JP)
(72) Inventor: YOSHII, Isamu Matsushita Electric Industrial Co.Ltd, Chuo-ku, Osaka 540-6319 (JP)
(74) Representative: Grünecker, Kinkeldey, Stockmair & Schwanhäusser Anwaltssozietät
(86) International application number: PCT/JP2005/020198
(87) International publication number: WO 2006/049203

(57) **Abstract**

Radio communication equipment by which reproduction of application data is not interrupted nor disabled even when the application data requiring a high throughput is transmitted by radio. In the equipment, an MCS deciding section (113) has, for example, an MCS setting table shown in table 1, selects an MCS having the best propagation path characteristics based on channel quality information inputted from a reception RF section (111), compares the delay time of the selected MCS with an application data allowable delay time informed from a delay time calculating part (112), and decides the MCS whose delay time is equal to the application data allowable delay time or shorter.

## Description

### Technical Field

The present invention relates to a radio communication method, radio communication system and radio communication apparatus that determine a combination of a modulation scheme and coding rate (MCS: Modulation and Coding Scheme) according to the propagation path state.

### Background Art

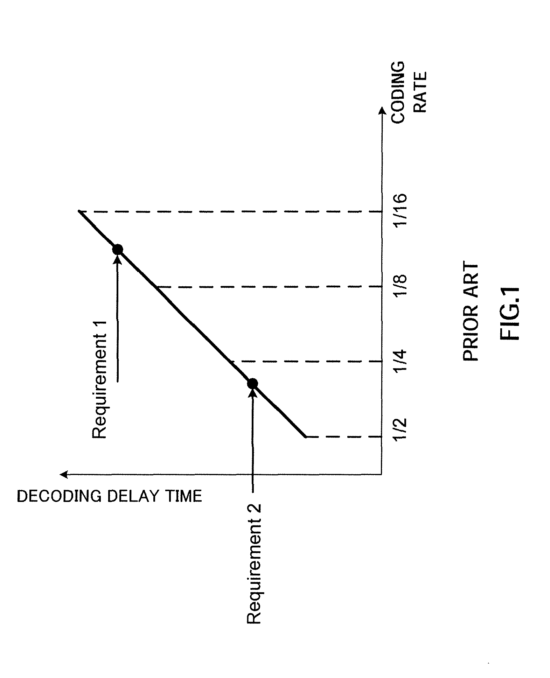

Conventionally, in radio communication that handles multimedia applications, the required delay time and communication quality differ for each application. On the other hand, in a radio communication system where interference of other cells is not whitened by spreading, but whitened by decreasing the coding rate, the decoding time for decoding a signal at a low coding rate becomes longer. For example, as shown in FIG.1, the delay time that occurs when the encoded signal is decoded becomes longer in accordance with a decrease in the coding rate of MCS.

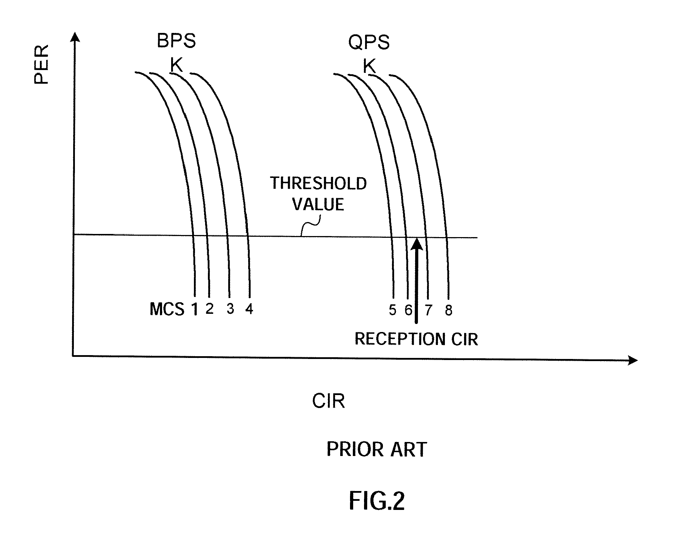

Normally, in a radio communication system that uses MCS, based on the index of PER (Packet Error Rate) to CIR (Committed Information Rate) as shown in FIG.2, PER characteristics in the radio communication system and the required PER are compared, and thereby a PER threshold is calculated, and the MCS is determined based on that threshold (see, for example, Non-Patent Document 1). The setting table for MCS 1 to MCS 8 shown in FIG.2 is illustrated in the following "Table 1".

**[Table 1]**

| MCS number | Modulation scheme | Coding rate | Repetition | Total (Resource Rate) |
|---|---|---|---|---|
| 1 | BPSK | 1/16 | 1 | 1/16 |
| 2 | BPSK | 1/8 | 1/2 | 1/16 |
| 3 | BPSK | 1/4 | 1/4 | 1/16 |
| 4 | BPSK | 1/2 | 1/8 | 1/16 |
| 5 | QPSK | 1/16 | 1 | 1/8 |
| 6 | QPSK | 1/8 | 1/2 | 1/8 |
| 7 | QPSK | 1/4 | 1/4 | 1/8 |
| 8 | QPSK | 1/2 | 1/8 | 1/8 |

The "Resource Rate" in Table 1 indicates the ratio (bit/s/Hz) of information bits to all resources. One MCS is determined for one resource rate.

Here, in the conventional MCS determination method, when the reception CIR in the radio communication system is as shown in FIG.2,--when the reception CIR is between MCS 6 and MCS 7--, for example, search is performed starting from the MCS with the higher resource rate, and therefore MCS 6 having the best characteristics is selected.
Non-Patent Document 1: "Multiplexing and channel coding (FDD)" (Release 5), 3GPP TSG RAN TS 25.212 V5.6.0

### Disclosure of the Invention

### Problems to be Solved by the Invention

However, in the conventional MCS determination method, there is a problem that, when the reception CIR is as shown in FIG.2, the delay time (time required for demodulating and decoding a coded signal) of the selected MCS 6 satisfies the requirement of Requirement 1 if the requirement of application data to be radio transmitted is Requirement 1, but does not satisfy the requirement of Requirement 2 if the requirement is Requirement 2. Further, when the delay time of the MCS selected in this way exceeds the allowable delay time of the application data, there is a problem that the playback of the application data results in interruption or failure.

It is therefore an object of the present invention to provide a radio communication method, or the like that does not cause playback interruption or failure even when application data requiring high throughput is radio transmitted.

### Means for Solving the Problem

The radio communication method according to the present invention has the steps of: measuring a state of a propagation path on which application data is radio transmitted; determining a combination of a coding rate and modulation scheme where the time required for demodulation and decoding is less than or equal to an allowable delay time of the application data based on the measured propagation path state; encoding the application data at the determined coding rate; modulating the encoded application data using the determined modulation scheme; and radio transmitting the modulated application data.

The radio communication system according to the present invention employs a configuration having: a first radio communication apparatus that has: a first reception section that receives a first radio signal including application data; a measurement section that measures a propagation path state based on the received first radio signal; and a first transmission section that radio transmits the measurement result of the propagation path state; and a second radio communication apparatus that has: a second reception section that receives the measurement result of the propagation path state; a determination section that determinates a combination of a coding rate and modulation scheme where the time required for demodulation and decoding is less than or equal to an allowable delay time of the application data based on the measured propagation path state; an encoding section that encodes the application data at the determined coding rate; a modulation section that modulates the encoded application data using the determined modulation scheme; and a second transmission section that radio transmits the modulated application data.

The radio communication apparatus according to the present invention employs a configuration having: a determination section that determines a combination of a coding rate and modulation scheme where the time required for demodulation and decoding is less than or equal to an allowable delay time of the application data according to a state of a propagation path on which application data is radio transmitted; an encoding section that encodes the application data at the determined coding rate; a modulation section that modulates the encoded application data using the determined modulation scheme; and a transmission section that radio transmits the modulated application data.

### Advantageous Effect of the Invention

According to the present invention, MCS where the time required for demodulating and decoding application data, that is, delay time, is less than or equal to the allowable delay time of the application data, is determined based on the state of the propagation path on which the application data is radio transmitted, so that it is possible to prevent playback interruption and failure even when the application data requires high throughput.

### Brief Description of Drawings

FIG.1 shows an example of the correlation between the coding rate and delay time of MCS;
FIG.2 shows an example of an index of PER to CIR for each MCS;
FIG.3 is a block diagram showing the main configuration of a radio communication apparatus according to Embodiment 1;
FIG.4 is another block diagram showing the main configuration of the radio communication apparatus according to Embodiment 1;
FIG.5 is a flowchart explaining the operation of the radio communication apparatus according to Embodiment 1;
FIG.6 is a flowchart explaining a modified example of the radio communication apparatus according to Embodiment 1;
FIG.7 is a block diagram showing the configuration of an encoder of Reference Example 1;
FIG.8 is a block diagram showing the configuration of a decoder of Reference Example 1;
FIG.9 is another block diagram showing the configuration of the encoder of Reference Example 1;
FIG.10 is still another block diagram showing the configuration of the encoder of Reference Example 1;
FIG.11 is a block diagram showing the configuration of an encoder of Reference Example 2; and
FIG.12 is another block diagram showing the configuration of the encoder of Reference Example 2.

### Best Mode for Carrying Out the Invention

Now embodiments of the present invention will be described in detail with reference to the accompanying drawings.

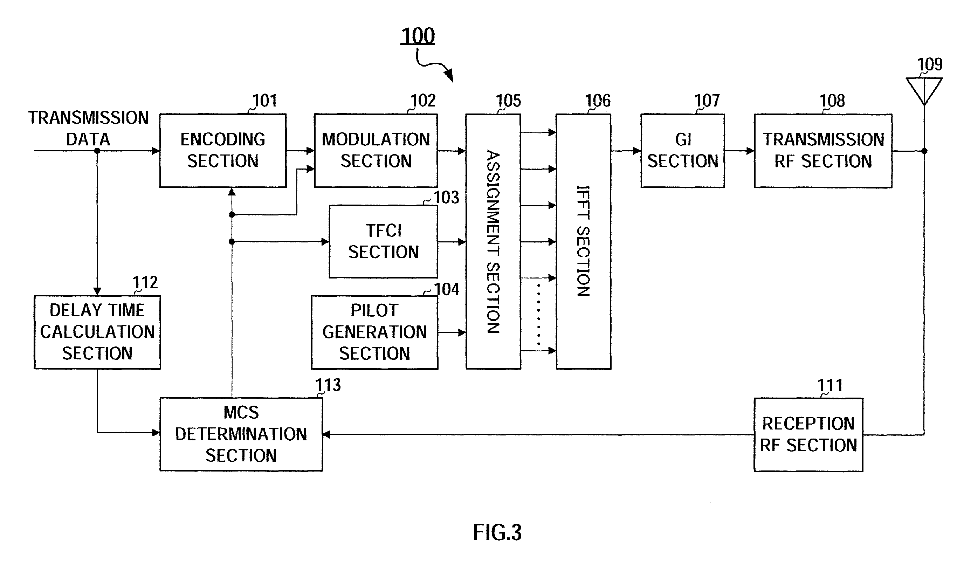

FIG.3 is a block diagram showing the main configuration of radio communication apparatus 100 according to Embodiment 1 of the present invention. Radio communication apparatus 100 is provided to a base station apparatus, or the like, that transmits application data to a communication terminal apparatus.

Radio communication apparatus 100 has encoding section 101, modulation section 102, TFCI (Transport Format Combination Indicator) section 103, pilot generation section 104, assignment section 105, IFFT (Inverse Fast Fourier Transform) section 106, GI (Guard Interval) section 107, transmission RF (Radio Frequency) section 108, antenna element 109, reception RF section 111, delay time calculation section 112 and MCS determination section 113.

Encoding section 101 encodes transmission data, which is application data, at a coding rate reported from MCS determination section 113 described later, and inputs the encoded transmission data to modulation section 102.

Modulation section 102 modulates the transmission data inputted from encoding section 101 using the modulation scheme reported from MCS determination section 113, and inputs the modulated transmission data to assignment section 105.

TFCI section 103 generates MCS information that indicates the content of the coding rate and modulation scheme reported from MCS determination section 113, and inputs the generated MCS information to assignment section 105.

Pilot generation section 104 periodically generates a pilot signal and inputs the generated pilot signal to assignment section 105.

Assignment section 105 adopts a configuration including a heretofore known interleaver, converts the transmission data inputted from modulation section 102, the MCS information inputted from TFCI section 103 and the pilot signal inputted from pilot generation section 104 to parallel signals, respectively, multiplexes the interleaved parallel signals and inputs the multiplexed parallel signals to IFFT section 106.

IFFT section 106 performs IFFT processing on the parallel signals inputted from assignment section 105 to generate an OFDM (Orthogonal Frequency Division Multiplexing) signal, and inputs the generated OFDM signal to GI section 107.

GI section 107 inserts a guard interval in the OFDM signal inputted from IFFT section 106, and inputs the OFDM signal after guard interval insertion to transmission RF section 108.

Transmission RF section 108 amplifies the OFDM signal inputted from GI section 107 after frequency conversion to generate a radio signal, and radio transmits the generated radio signal toward radio communication apparatus 200 described later via antenna element 109.

Reception RF section 111 receives the radio signal from radio communication apparatus 200 via antenna element 109, and, after performing frequency conversion and amplification on received signal, extracts the channel quality information that indicates the propagation path state measured by radio communication apparatus 200 included in the received signal, and inputs the extracted channel quality information to MCS determination section 113.

Delay time calculation section 112 determines the type of the transmission data--application data--, calculates the allowable delay time of the application data, and reports the calculated allowable delay time of the application data to MCS determination section 113.

MCS determination section 113 has an MCS setting table shown in Table 1, for example, and selects the MCS with the best propagation path characteristics based on the channel quality information inputted from reception RF section 111, compares the delay time of the selected MCS with the allowable delay time of the application data reported from delay time calculation section 112, and determines the MCS that gives a delay time less than or equal to the allowable delay time of the application data. Then, MCS determination section 113 reports the coding rate and modulation scheme of the determined MCS to encoding section 101, modulation section 102 and TFCI section 103. The MCS determination method of MCS determination section 113 will be described later.

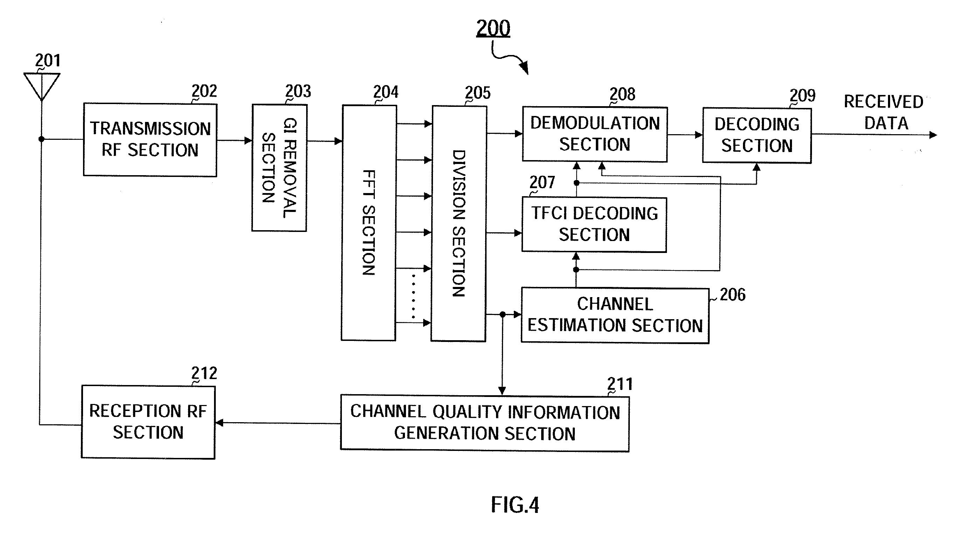

FIG.4 is a block diagram showing the main configuration of radio communication apparatus 200 according to this embodiment. When radio communication apparatus 100 is a base station apparatus, radio communication apparatus 200 is provided to a communication terminal apparatus such as a mobile telephone that plays back application data transmitted from radio from radio communication apparatus 100.

Radio communication apparatus 200 has antenna 201, transmission RF section 202, GI removal section 203, FFT (Fast Fourier Transform) section 204, division section 205, channel estimation section 206, TFCI decoding section 207, demodulation section 208, decoding section 209, channel quality information generation section 211 and reception RF section 212.

Transmission RF section 202 receives the radio signal from radio communication apparatus 100 via antenna element 201, and, after performing frequency conversion and amplification on the received signal, inputs the received signal to GI removal section 203.

GI removal section 203 removes the guard interval inserted in the received signal inputted from transmission RF section 202 and then inputs the received signal to FFT section 204.

FFT section 204 converts the received signal inputted from GI removal section 203 to a parallel signal, performs FFT processing on the parallel signal, and then inputs the parallel signal to division section 205.

Division section 205 divides the parallel signal inputted from FFT section 204 into application data, MCS information and a pilot signal, inputs the application data after deinterleaving to demodulation section 208, inputs the MCS information after deinterleaving to TFCI decoding section 207, and inputs the pilot signal after deinterleaving to channel estimation section 206 and channel quality information generation section 211.

Channel estimation section 206 performs channel estimation using the pilot signal inputted from division section 205, and inputs the calculated channel estimation value to TFCI decoding section 207 and demodulation section 208.

TFCI decoding section 207 has the same setting table as the MCS setting table held by MCS determination section 113, and, based on the MCS information inputted from division section 205 and the channel estimation value inputted from channel estimation section 206, specifies the coding rate and modulation scheme of theMCS determined by MCS determination section 113. Then, TFCI decoding section 207 reports the specified coding rate and modulation scheme to demodulation section 208 and decoding section 209.

Demodulation section 208 demodulates the application data inputted from division section 205 using the demodulation scheme corresponding to the modulation scheme reported from TFCI decoding section 207 while referring to the channel estimation value inputted from channel estimation section 206, and inputs the demodulated application data to decoding section 209.

Decoding section 209 decodes the application data inputted from demodulation section 208 using the decoding scheme corresponding to the coding rate reported from TFCI decoding section 207, and inputs the decoded application data as received data to a control section (not shown), for example.

Channel quality information generation section 211 measures the propagation path state based on the pilot signal inputted from division section 205, generates channel quality information such as reception CIR indicating the measurement result, and inputs the channel quality information to reception RF section 212.

Reception RF section 212 amplifies the channel quality information inputted from channel quality information generation section 211 after frequency conversion to generate a radio signal, and radio transmits the generated radio signal toward radio communication apparatus 100 via antenna element 201.

Next, the operation of radio communication apparatus 100 according to the present invention will be described.

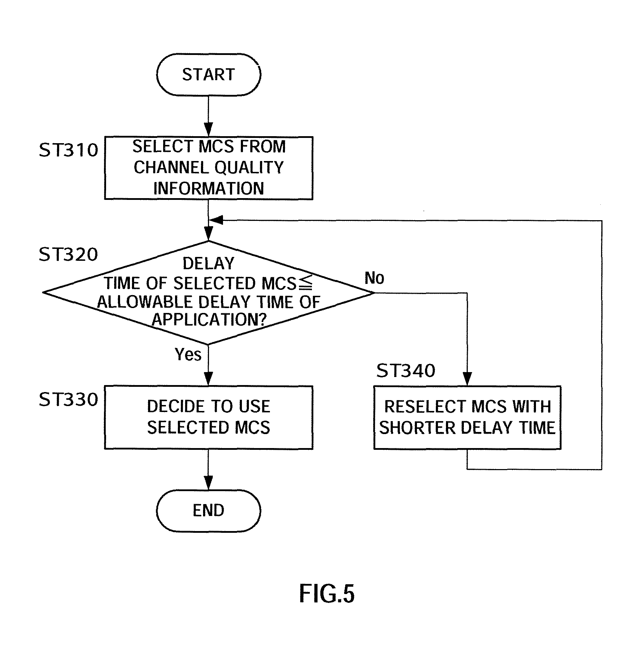

FIG.5 is a flowchart explaining a radio communication method according to the present invention.

First, in step ST310, MCS determination section 113 selects the MCS having the best propagation path characteristics based on the channel quality information generated by channel quality information generation section 211.

Subsequently, in step ST320, MCS determination section 113 compares the delay time of the MCS selected in step ST310 with the allowable delay time of the application reported from delay time calculation section 112, and judges whether or not the delay time of the selected MCS is less than or equal to the allowable delay time of the application.

Subsequently, in step ST330, in a case where it is judged in step ST320 that the selected MCS delay time is less than or equal to the allowable delay time of the application, MCS determination section 113 determines to use the selected MCS.

On the other hand, in step ST340, when it is judged in step ST320 that the delay time of the selected MCS is not less than or equal to the allowable delay time of the application, MCS determination section 113 reselects an MCS with a delay time shorter than that of the selected MCS and executes step ST320 once again.

More specifically, for example, when the channel quality information generated by channel quality information generation section 211 is the reception CIR shown in FIG.2, first, MCS determination section 113 selects MCS 6 in step ST310. Subsequently, in step ST320, MCS determination section 113 calculates the delay time of coding rate 1/8 of MCS 6 from FIG.1, or the like, and compares the delay time of MCS 6 with the allowable delay time of the application data such as the delay time of Requirement 1 of FIG.1. Here, the delay time of MCS 6 is less than or equal to the delay time of Requirement 1, and therefore MCS determination section 113 determines to use MCS 6 in step ST330.

On the other hand, when the allowable delay time of the application data is the delay time of Requirement 2 of FIG.1, the delay time of MCS 6 is not less than or equal to the delay time of Requirement 2 in step ST320, and therefore MCS determination section 113 executes step ST340 and reselects MCS 5 having the next best propagation path characteristics following MCS 6. Subsequently, MCS determination section 113 executes step ST320 once again, but, similar to the above, the delay time of MCS 5 is not less than or equal to the delay time of Requirement 2, and therefore MCS determination section 113 executes step ST340 once again and selects MCS 4 having the next best propagation path characteristics following MCS 5. Subsequently, MCS determination section 113 executes step ST320, and, the delay time of MCS 4 is less than or equal to the delay time of Requirement 2, and therefore MCS determination section 113 determines to use MCS 4 in step ST330.

In this way, according to this embodiment, MCS determination section 113 determines to use MCS having the best propagation path characteristics among those having a delay time less than or equal to the allowable delay time of the application based on the channel quality information generated by channel quality information generation section 211, so that it is possible to prevent playback interruption and playback failure of the application data in radio communication apparatus 200, even when the application data which is radio transmitted from radio communication apparatus 100 to radio communication apparatus 200 requires high throughput.

Furthermore, this embodiment may be applied and modified as follows.

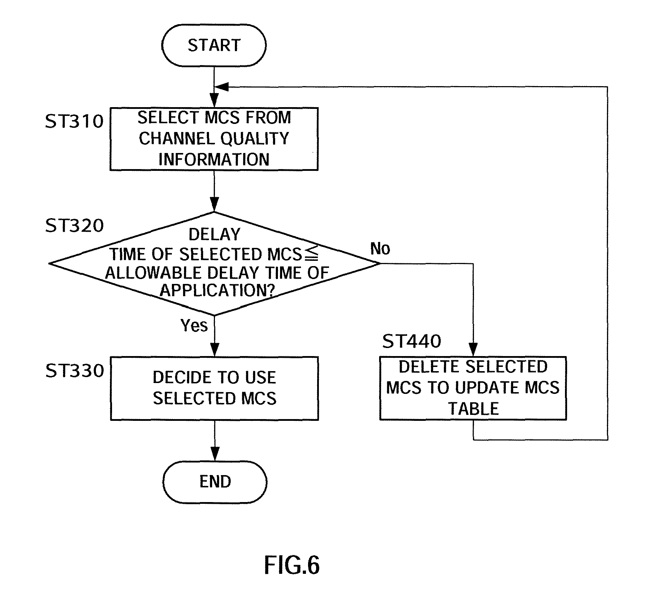

In this embodiment, although the case has been described where MCS determination section 113 selects an MCS having a shorter delay time than that of the selected MCS and executes step ST320 once again when it is judged that the delay time of the selected MCS is not less than or equal to the allowable delay time of the application, the present invention is not limited to this, and, as shown in FIG. 6, for example, the selectedMCSmaybe deleted in step ST440 to update the MCS setting table held by MCS determination section 113, and, in the following step ST310, the MCS may be reselected using the updated MCS setting table.

Further, in this embodiment, although the case has been described where radio communication apparatus 200 measures the propagation path state and reports the measured state to radio communication apparatus 100, the present invention is not limited to this, and, for example, radio communication apparatus 200 may generate and transmit a pilot signal to radio communication apparatus 100, and radio communication apparatus 100 may measure the propagation path state using that pilot signal and subsequently determine the MCS.

Further, in this embodiment, although MCS is selected based on the index of the allowable delay time of the same resource rate using Repetition OFDM and Low Rate Code OFDM, it is also possible to use a similar concept for OFCDM that uses spreading.

### (Reference Example 1)

In Embodiment 1, although the decoding delay time in MCSs having different coding rates is focused, there is a case where the delay time differs depending on the selection of the coding method, or a case where the MCS threshold values differ. The MCS may be determined by focusing on such aspects, taking into consideration the level of the reception CIR and the length of the decoding delay.

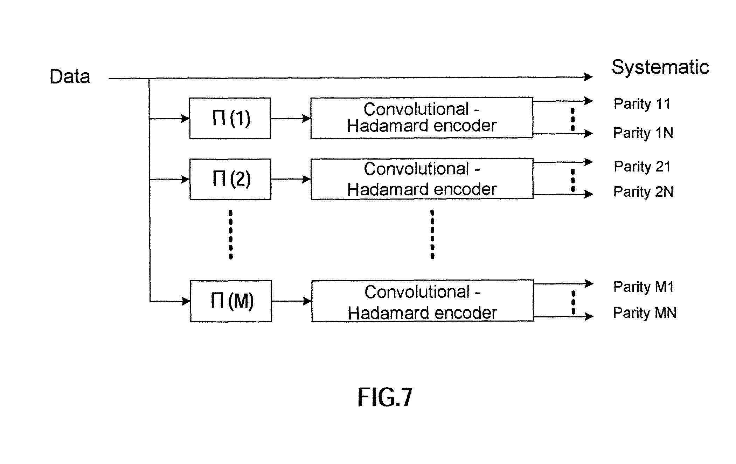

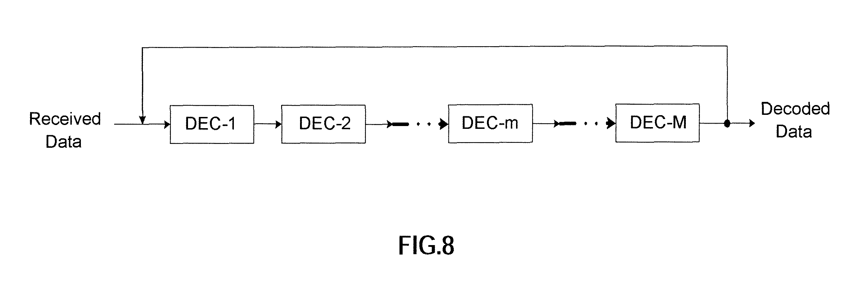

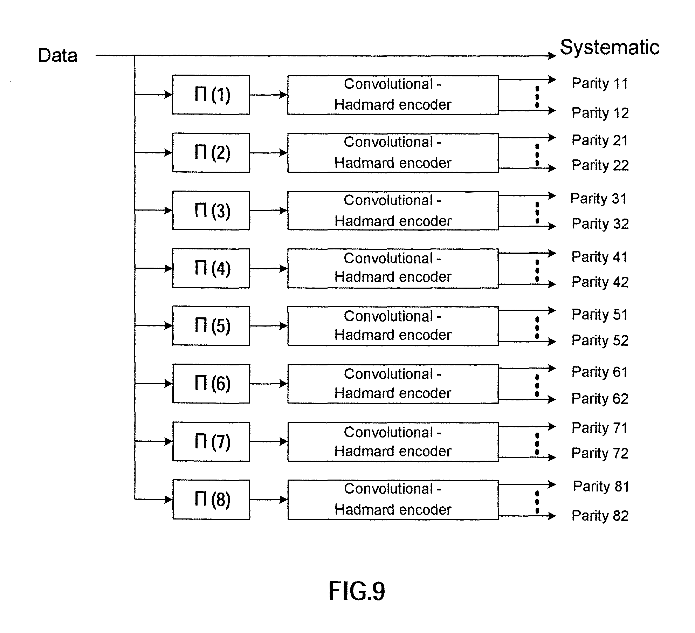

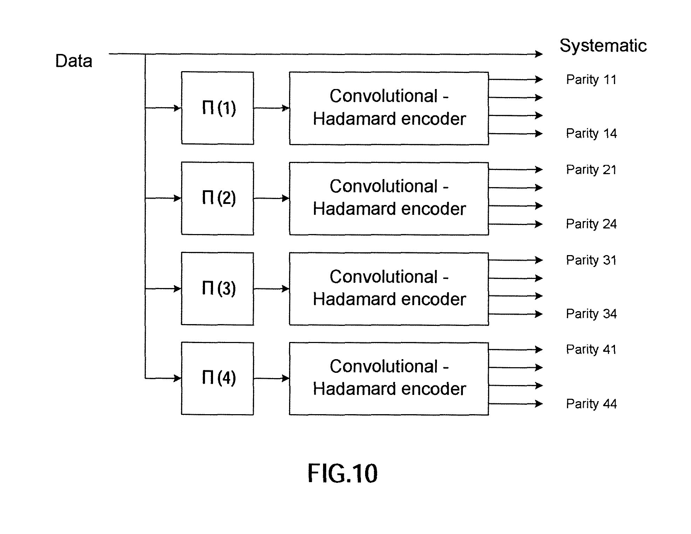

For example, in a case of low rate Hadamard code as shown in FIG.7, the configuration of the decoder shown in FIG.8 becomes complicated when the number "M" of convolutional encoders is large, and therefore the decoding time increases. However, a larger M contributes to the expansion of coding space, and therefore PER improves. The configurations of two encoders when the coding rate R = 1/17 are shown in FIG.9 and FIG.10. A tradeoff as shown in the following "Table 2" exists between the encoder shown in FIG. 9 and the encoder shown in FIG. 10, and therefore the MCS and the configuration of the encoder are determined taking into consideration this tradeoff.

**[Table 2]**

| | M | N | PER | Decoding Delay |
|---|---|---|---|---|
| Encoder shown in FIG.9 | 8 | 2 | Good | Long |
| Encoder shown in FIG.10 | 4 | 4 | Bad | Short |

### (Reference Example 2)

Similar to Reference Example 1, there is a case where the decoding delay time and MCS threshold value differ depending on the puncturing method, even when the coding rate is the same. The MCS and puncturing pattern are selected based on the reception CIR so as to satisfy the decoding delay time.

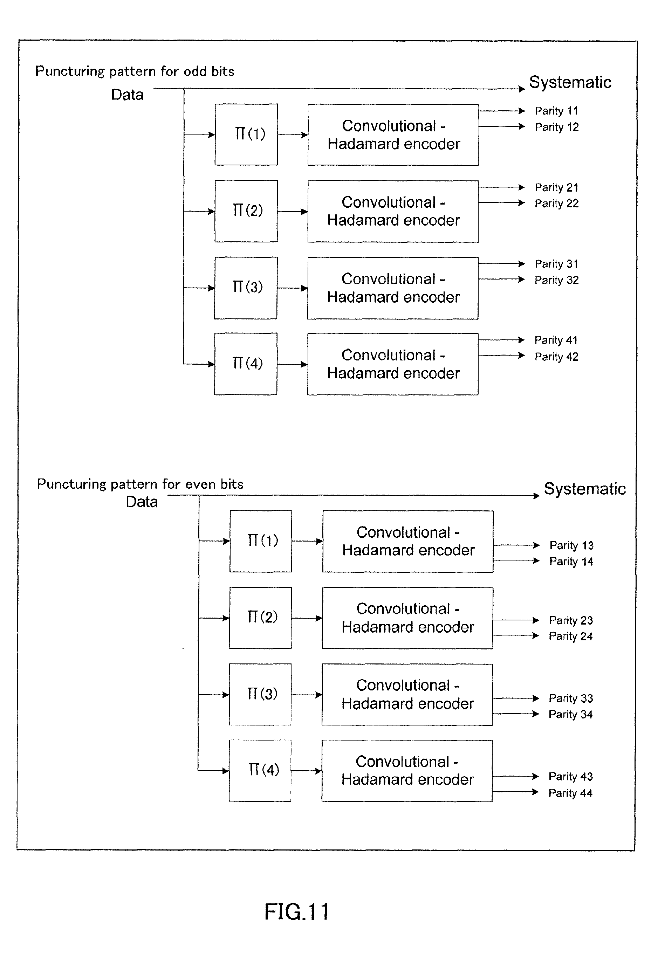

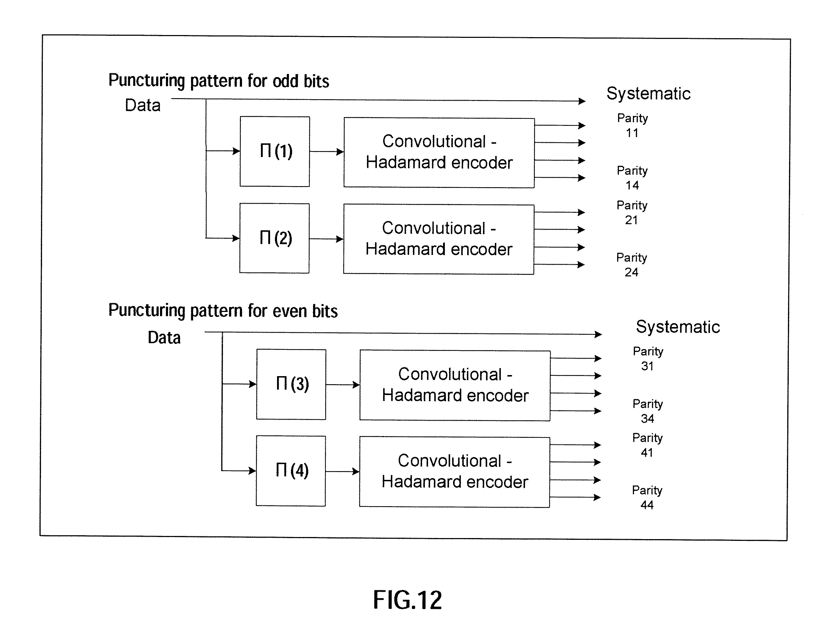

For example, when R= 1 / 9 is realized by puncturing M=4 and N=4 encoders, puncturing patterns as shown in FIG.11 and FIG.12 exist with a tradeoff as shown in "Table 3" below. The MCS and puncturing method are selected taking into consideration this tradeoff and the required delay time.

**[Table 3]**

| | M | N | PER | Decoding Delay |
|---|---|---|---|---|
| Puncturing method shown in FIG.11 | 8 | 2 | Good | Long |
| Puncturing method shown in FIG.12 | 4 | 4 | Bad | Short |

### (Reference Example 3)

When the delay is large due to MIMO reception, the system may be designed so that MIMO reception is not performed.

Furthermore, each function block used to explain the above-described embodiments is typically implemented as an LSI constituted by an integrated circuit. These may be individual chips or may partially or totally contained on a single chip.

Here, each function block is described as an LSI, but this may also be referred to as "IC", "system LSI", "super LSI", "ultra LSI" depending on differing extents of integration.

Further, the method of circuit integration is not limited to LSI's, and implementation using dedicated circuitry or general purpose processors is also possible. After LSI manufacture, utilization of a programmable FPGA (Field Programmable Gate Array) or a reconfigurable processor in which connections and settings of circuit cells within an LSI can be reconfigured is also possible.

Further, if integrated circuit technology comes out to replace LSI's as a result of the development of semiconductor technology or a derivative other technology, it is naturally also possible to carry out function block integration using this technology. Application in biotechnology is also possible.

The present application is based on Japanese Patent Application No.2004-321883, filed on November 5, 2004, the entire content of which is expressly incorporated by reference herein.

### Industrial Applicability

The radio communication method, or the like according to the present invention provides the advantage of preventing playback interruption and playback failure even when the radio transmitted application data requires high throughput, and is useful as a next generation radio communication method, or the like that radio transmits application data such as animation data which always requires high throughput.

## Claims

1. A radio communication method comprising the steps of:
measuring a state of a propagation path on which application data is radio transmitted;
determining a combination of a coding rate and modulation scheme where the time required for demodulation and decoding is less than or equal to an allowable delay time of the application data based on the measured propagation path state;
encoding the application data at the determined coding rate;
modulating the encoded application data using the determined modulation scheme; and
radio transmitting the modulated application data.

2. A radio communication system comprising:
a first radio communication apparatus that comprises:
a first reception section that receives a first radio signal including application data;
a measurement section that measures a propagation path state based on the received first radio signal; and
a first transmission section that radio transmits the measurement result of the propagation path state; and a second radio communication apparatus that comprises:
a second reception section that receives the measurement result of the propagation path state;
a determination section that determines a combination of a coding rate and modulation scheme where the time required for demodulation and decoding is less than or equal to an allowable delay time of the application data based on the measured propagation path state;
an encoding section that encodes the application data at the determined coding rate;
a modulation section that modulates the encoded application data using the determined modulation scheme; and
a second transmission section that radio transmits the modulated application data.

3. A radio communication apparatus comprising:
a determination section that determines a combination of a coding rate and modulation scheme where the time required for demodulation and decoding is less than or equal to an allowable delay time of the application data according to a state of a propagation path on which application data is radio transmitted;
an encoding section that encodes the application data at the determined coding rate;
a modulation section that modulates the encoded application data using the determined modulation scheme; and
a transmission section that radio transmits the modulated application data.
